# EUROPEAN PATENT APPLICATION

(11) **EP 4 661 216 A1**
(43) Date of publication of application: **10.12.2025**
(21) Application number: 25180222.9
(22) Date of filing: 02.06.2025
(51) Int. Cl.: H01R 12/58, H01R 13/66, F21V 23/06

(54) **PRINTED CIRCUIT BOARD CONNECTION FOR AN ELECTRICAL CONNECTOR SYSTEM**

(30) Priority: 04.06.2024 US 202418733727
(71) Applicant: TE Connectivity Solutions GmbH, 8200 Schaffhausen (CH)
(72) Inventor: King, Alexander Raymond, Middletown, 17057 (US); Mostoller, Matthew Edward, Middletown, 17057 (US)
(74) Representative: Ashton, Gareth Mark

(57) **Abstract**

An electrical connector system (100) includes a receptacle connector (104) having a receptacle housing (120) holding receptacle contacts (122) in contact channels (124) with poke-in contacts (144). The electrical connector system (100) includes a printed circuit board assembly (110) coupled to the receptacle connector (104) having a printed circuit board (200), an electrical component (202) mounted to a first surface (212) of a substrate (210) of the printed circuit board (200), and mating pins (250) extending from a second surface (214) of the substrate (210). Each mating pin (250) has a mating end (252) plugged into poke-in openings (130) of the receptacle housing (120) to electrically connect the mating pins (250) to the poke-in contacts (144) of the receptacle connector (104).

## Description

### BACKGROUND OF THE INVENTION

The subject matter herein relates generally to electrical connector systems.

Electrical connector systems typically include electrical connectors that connect various components. For example, in light fixtures, electrical connectors may be used to connect power to light elements and control modules for the light elements. Some systems have a need for additional control or processing within the system. For example, some systems may incorporate a surge protection device into the system. Common prior art systems provide the surge protection device in line with the power circuit by connecting the surge protection device with a wire splice to the power wires. The surge protection device may be incorporated in series or in parallel with the power lines. Such system requires attachment of the components using wires and soldering, crimping or otherwise connecting the wires of the surge protection device to the main power wires requiring separate attachment of each wire. The process may further require placement of heat shrink or other sealing of the connections. The attachment is manual and labor intensive. Additionally, the splice typically hangs or dangles from the main wires within the enclosure or mechanically affixed or otherwise mounted to the fixture.

A need remains for a method to connect an electronic device to an electrical circuit without additional splicing steps, splicing equipment, tools, and mechanical mounting features.

### BRIEF DESCRIPTION OF THE INVENTION

In one embodiment, an electrical connector system is provided and includes a receptacle connector that includes a receptacle housing and receptacle contacts configured to be mated with mating contacts of a mating connector. The receptacle housing has contact channels holding the receptacle contacts. The receptacle housing has poke-in openings open to the contact channels. The receptacle contacts include poke-in contacts. The electrical connector system includes a printed circuit board assembly coupled to the receptacle connector. The printed circuit board assembly includes a printed circuit board that includes a substrate having a first surface and a second surface. The printed circuit board includes circuits on the substrate. The printed circuit board includes an electrical component mounted to the first surface of the substrate and electrically connected to the corresponding or a corresponding said circuit on the substrate. The printed circuit board includes mating pins extending from the second surface of the substrate. Each mating pin has a mating end and a terminating end. The terminating end is terminated to the corresponding circuit on the substrate to electrically connect the mating pin to the electrical component. The mating ends of the mating pins are plugged into poke-in openings or the or said or the corresponding poke-in openings of the receptacle connector to electrically connect the mating pins to the poke-in contacts of the receptacle connector.

In another embodiment, a printed circuit board assembly is provided and includes a printed circuit board that includes a substrate having a first surface and a second surface. The printed circuit board includes circuits on the substrate. The printed circuit board assembly includes an electrical component mounted to the first surface of the substrate and electrically connected to the corresponding or a corresponding said circuit on the substrate. The printed circuit board assembly includes mating pins extending from the second surface of the substrate. Each mating pin has a mating end and a terminating end. The terminating end is terminated to the corresponding circuit on the substrate to electrically connect the mating pin to the electrical component. The mating ends of the mating pins are configured to be plugged into poke-in openings of a receptacle connector to electrically connect the mating pins to poke-in contacts of the receptacle connector.

### BRIEF DESCRIPTION OF THE DRAWINGS

Figure 1 illustrates an electrical connector system in accordance with an exemplary embodiment for an electrical device.
Figure 2 is a perspective view of a portion of the electrical connector system in accordance with an exemplary embodiment.
Figure 3 is a perspective view of the printed circuit board assembly in accordance with an exemplary embodiment.
Figure 4 is a plan view of the printed circuit board assembly in accordance with an exemplary embodiment.
Figure 5 is an exploded view of a portion of the printed circuit board assembly in accordance with an exemplary embodiment.
Figure 6 is an exploded view of a portion of the printed circuit board assembly in accordance with an exemplary embodiment.
Figure 7 is a perspective view of a portion of the electrical connector system in accordance with an exemplary embodiment showing the printed circuit board assembly coupled to the receptacle connector.
Figure 8 is a sectional view of a portion of the electrical connector system in accordance with an exemplary embodiment.
Figure 9 is a perspective view of a portion of the electrical connector system showing the printed circuit board assembly poised for coupling to the receptacle connector in accordance with an exemplary embodiment.
Figure 10 is a perspective view of a portion of the electrical connector system showing the printed circuit board assembly coupled to the receptacle connector in accordance with an exemplary embodiment.
Figure 11 is a side view of a portion of the electrical connector system in accordance with an exemplary embodiment.
Figure 12 is a plan view of a portion of the electrical connector system in accordance with an exemplary embodiment.

### DETAILED DESCRIPTION OF THE INVENTION

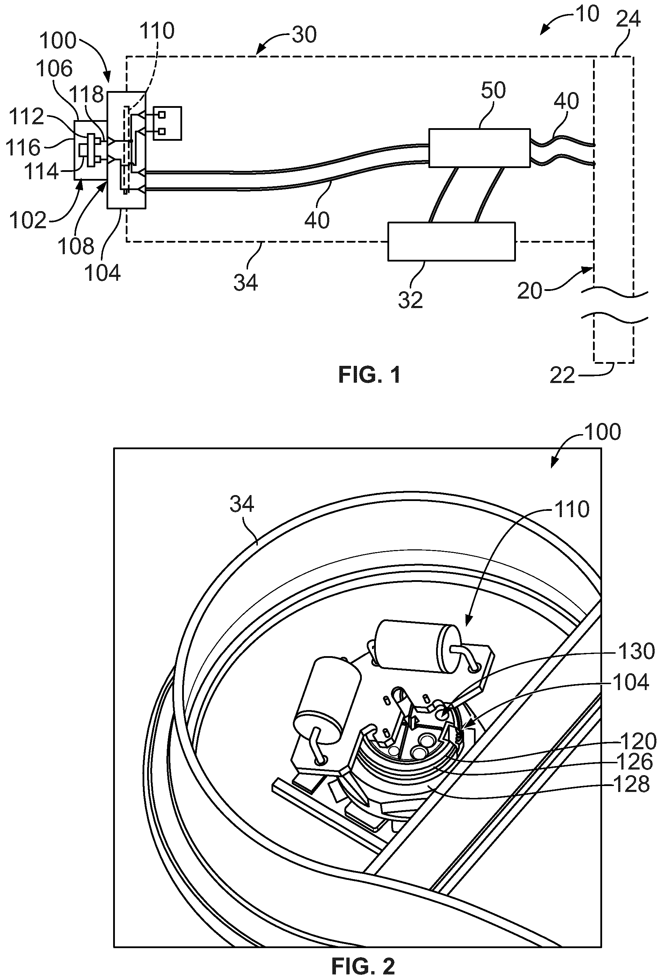

Figure 1 illustrates an electrical connector system 100 in accordance with an exemplary embodiment for an electrical device 10. The electrical connector system 100 may be utilized as part of a control system for controlling the electrical device 10. For example, the electrical connector system 100 may control power to/from the electrical device 10. The electrical connector system 100 may control data signaling to/from the electrical device 10. The electrical connector system 100 may provide circuit protection, such as line voltage surge suppression, power filtering, power buffering, lightning strike protection, power conversion. For example, the electrical connector system 100 may include one or more surge protection devices. The electrical connector system 100 may provide signal processing, signal monitoring, level shifting or other processing for data signals. The electrical connector system 100 may provide data communication, such as wireless communication.

The electrical connector system 100 may provide smart control for the electrical device 10. For example, in various embodiments, the electrical connector system 100 includes a control device 102 for controlling the electrical device 10. The control device 102 may be connected to a power driver 50 to control power supply to the electrical device 10. The power driver 50 may control other components of the electrical device 10, such as a light element to produce the power for the light output. For example, the power driver 50 may be an LED driver. The output level of the LED driver can be controlled via control signals generated by the control module 102 and transmitted to the power driver via wires 40. The control device 102 may be a sensor to control the electrical device 10. The control device 102 may be mounted to the electrical device 10, such as to an exterior of the electrical device 10 to provide external control for the electrical device 10. The control device 102 may be removable and replaceable. Components of the control device 102 are removable and replaceable, such as to repair or upgrade the system. The control device 102 may be modular in design to allow connection of different types of control options for the electrical device 10.

In an exemplary embodiment, the electrical device 10 is a light fixture 30, such as an outdoor light fixture. The light fixture 30 includes one or more light elements 32. In various embodiments, the light fixture 30 may include a pole 20 with the light elements 32 at the top of the pole 20. The pole 20 extends vertically between a base 22 at the bottom and a tip 24 at the top. The base 22 may be mounted to the ground. The light elements 32 are provided in a fixture housing 34 at or near the tip 24 of the pole 20. The control device 102 may be mounted the pole 20 and/or the fixture housing 34. In other embodiments, the light fixture 30 may be provided without the pole 20, such as being mounted directly to a building or wall. In other various embodiments, the electrical device 10 may be another type of device other than a light fixture.

The control system for the electrical device 10 may include components located in the interior of the pole 20 and/or the fixture housing 34 of the light fixture 30. For example, the control system may include a printed circuit board assembly having components or elements controlling operations of the light element 32. For example, the control system may turn the light elements on and off. The control system may control a dimming function of the light element 32. For example, the control device 102 of the control system may control functions of the light fixture 30.

In an exemplary embodiment, the electrical device 10 includes wires 40 routed to the light fixture 30, such as within the interior of the pole 20 and/or within the interior of the fixture housing 34 of the light fixture 30. The electrical connector system 100 may create a connection between the electrical circuits internal to the light fixture 30 and the electrical circuits internal to the control device 102. The wires 40 may provide power to the light element 32. The wires 40 may send signals to/from the control device 102 to control operation of the light element 32. For example, the wires 40 may send control signals from a photosensor of the control device 102 to turn the light element 32 on or off at dusk and dawn based on the light levels in the environment around the light element 32. The control device 102 may include a relay for connecting/disconnecting power through the system. The wires 40 may carry communication and or control signals to modify light output of the system in response to motion signals generated by a motion detecting subsystem within the control module 102. Other types of sensors at the light fixture control module may send other types of signals for other control schemes.

In an exemplary embodiment, the electrical connector system 100 includes electrical connectors 104, 106 mated at a mating interface 108. The mating interface 108 is a separable mating interface allowing mating and unmating of the electrical connectors 104, 106. The electrical connector 104 and/or the electrical connector 106 may form part of the control device 102. In an exemplary embodiment, one of the electrical connectors, such as the electrical connector 104 is mounted to the fixture housing 34 and the other electrical connector 106 is removable from the electrical connector 104. For example, the first electrical connector 104 may be a receptacle connector and the second electrical connector 106 may be a plug connector configured to be plugged into the receptacle connector, or vice versa. In an exemplary embodiment, the electrical connector 104 includes a printed circuit board assembly 110 electrically connected to the electrical connector 104. For example, the printed circuit board assembly 110 may be directly coupled to the electrical connector 104. The printed circuit board assembly 110 may be mechanically and electrically connected to contacts of the electrical connector 104. The wires 40 are configured to be electrically connected to the electrical connector 104. For example, the wires 40 may be directly terminated to the contacts of the electrical connector 104. In other various embodiments, the wires 40 may be electrically connected to the context of the electrical connector 104 through the printed circuit board assembly 110.

In an exemplary embodiment, the control device 102 may additionally or alternatively include a printed circuit board assembly 112 electrically connected to the second electrical connector 106. For example, the printed circuit board assembly 112 may be directly coupled to the electrical connector 106. Optionally, the wires 40 may be electrically connected to the printed circuit board assembly 112. The printed circuit board assembly 112 may include control components, such as a microprocessor, a power driver, a communication module, or other types of control elements to control one or more operations of the electrical connector system 100. In an exemplary embodiment, the control device 102 includes one or more sensors 114 coupled to the printed circuit board assembly 112. The sensor 114 is used to sense environmental characteristics around the system, such as around the light fixture 30. For example, the sensor 114 may be a photosensor used to sense ambient light in the exterior environment around the light fixture 30 to turn the light fixture 30 on or off depending on the amount of ambient light. The sensor 114 may be a motion sensor used to detect motion around the light fixture 30, such as to control the main functions of the light fixture 30. Other types of sensors may be used in alternative embodiments. The sensor 114 may be housed within a housing 116 of the second electrical connector 106. In an exemplary embodiment, the housing 116 houses mating contacts 118 configured to be mated with the first electrical connector 104. For example, the mating contacts 118 may be plugged contacts configured to be plugged into the receptacle connector 104. In various embodiments, the electrical connector 106 is a twist lock plug connector configured to be mated with the receptacle connector 104 by a twist lock connection. For example, the plugged contacts 118 are plugged into the receptacle connector 104 and mated by twisting the plug connector 106 in a rotating direction relative to the plugged direction until the plugged contacts 118 are mated and locked to the receptacle contacts of the receptacle connector 104. Other types of connectors and contacts may be mated to the first electrical connector 104 in alternative embodiments.

Figure 2 is a perspective view of a portion of the electrical connector system 100 in accordance with an exemplary embodiment. Figure 2 shows the receptacle connector 104 mounted to the fixture housing 34. Figure 2 shows the printed circuit board assembly 110 coupled to the receptacle connector 104. The printed circuit board assembly 110 is directly coupled to the receptacle connector 104, such as being plugged into the receptacle connector 104 to mate with receptacle contacts of the receptacle connector 104. In an exemplary embodiment, the printed circuit board assembly 110 is mechanically coupled to the electrical connector 104 such that the printed circuit board assembly 110 is freestanding relative to the fixture housing 34 on the receptacle connector 104. For example, the fixture housing 34 does not include separate mounting features used to support the printed circuit board assembly 110. Rather, the direct connection of the printed circuit board assembly 110 to the receptacle connector 104 supports the printed circuit board assembly 110.

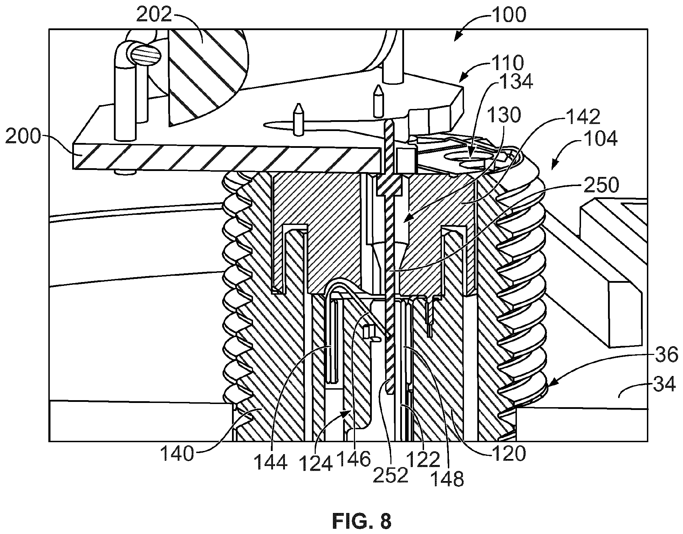

The receptacle connector 104 includes a receptacle housing 120 holding receptacle contacts 122 (shown in Figure 8) in contact channels 124. The receptacle housing 120 is manufactured from a dielectric material, such as a plastic material. The receptacle housing 120 may be a molded part. In the illustrated embodiment, the receptacle housing 120 is cylindrical, such as for twist lock mating with the mating plug connector 106 (shown in Figure 1). In an exemplary embodiment, the receptacle housing 120 includes external threads 126. The receptacle housing 120 is secured to the fixture housing 34 using a threaded nut 128 threadably coupled to the external threads 126 of the receptacle housing 120. The receptacle housing 120 may be connected to the fixture housing 34 by other means in alternative embodiments, such as using clips, latches, fasteners, adhesive, and the like. In an exemplary embodiment, the receptacle housing 120 includes poke-in openings 130 at a terminating end 132 of the receptacle housing 120. The printed circuit board assembly 110 is coupled to the receptacle housing 120 at the terminating end 132. For example, mating pins of the printed circuit board assembly 110 are plugged into the poke in openings 130 to electrically connect with the receptacle contacts 122. The mating pins allow for quick assembly of the printed circuit board assembly 110 with the receptacle connector 104. For example, a plurality of the mating pins may be simultaneously loaded into the corresponding poke in openings 130 to mechanically and electrically connect to the corresponding receptacle contacts 122.

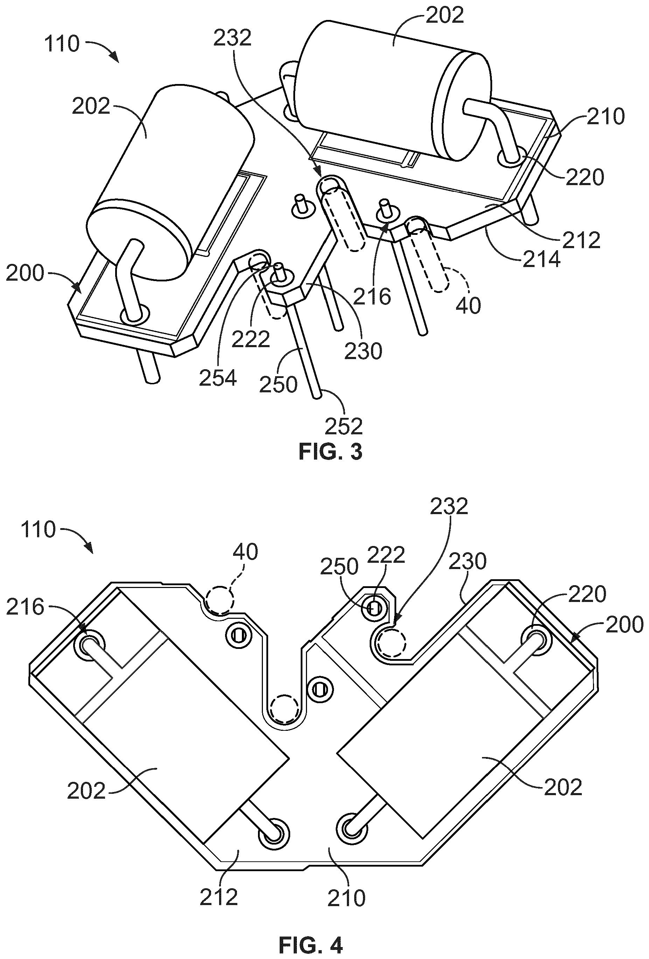

Figure 3 is a perspective view of the printed circuit board assembly 110 in accordance with an exemplary embodiment. Figure 4 is a plan view of the printed circuit board assembly 110 in accordance with an exemplary embodiment. In an exemplary embodiment, the printed circuit board assembly 110 includes a printed circuit board 200, one or more electrical components 202 mounted to the printed circuit board 200, and a plurality of mating pins 250 extending from the printed circuit board 200.

The printed circuit board 200 includes a substrate 210 having a first surface 212 and a second surface 214. The substrate 210 may be manufactured from FR-4 material, or other common circuit board materials. The substrate 210 may be a layered structure. The printed circuit board 200 includes circuits 216 on the substrate 210. The circuits 216 may be provided on one or more layers of the substrate 210. The circuits 216 are defined by conductors, such as traces, vias, pads, or other circuit conductors. The circuits 216 connect the electrical components 202 and the mating pins 250. The circuits 216 may connect other components.

In the illustrated orientation, the printed circuit board 200 is oriented such that the first surface 212 is a top surface and the second surface 214 is a bottom surface. However, the printed circuit board 200 may be arranged in other orientations within the system. In the illustrated embodiment, the electrical components 202 are mounted to the first surface 212. However, the electrical components 202 may additionally or alternatively be mounted to the second surface 214. In an exemplary embodiment, the printed circuit board 200 includes component conductors 220 configured to be electrically connected to the electrical components 202. For example, the component conductors 220 may include pads and/or vias. The electrical components 202 may be soldered to the component conductors 220.

In an exemplary embodiment, the printed circuit board 200 includes pin conductors 222. The mating pins 250 are electrically connected to the printed circuit board 200 at the pin conductors 222. In the illustrated embodiment, the pin conductors 222 include plated vias. The mating pins 250 are soldered to the plated vias. In alternative embodiments, the pin conductors 222 may include solder pads, such as on the second surface 214 and ends of the mating pins 250 may be soldered to the solder pads. In the illustrated embodiment, the mating pins 250 extend from the second surface 214, such as downward from the second surface 214 along pin axes perpendicular to the printed circuit board 200. However, the mating pins 250 may extend in different directions in alternative embodiments. For example, the mating pins 250 may be right angle pins extending in a direction generally parallel to the plane of the substrate 210 rather than extending perpendicular to the plane of the substrate 210.

In an exemplary embodiment, the substrate 210 includes an edge 230 around the perimeter of the substrate 210 extending between the first surface 212 and the second surface 214. In an exemplary embodiment, the printed circuit board 200 includes wire pockets 232 passing through the substrate 210. The wire pockets 232 are configured to receive the corresponding wires 40 (shown in Figure 1), which are electrically connected to the receptacle connector 104. In an exemplary embodiment, the wire pockets 232 are located in close proximity to the mating pins 250. For example, each mating pin 250 has a corresponding wire pocket 232 associated there with in close proximity, such as for mating the mating pins 250 and the wires 40 to the same receptacle contacts 122.

In the illustrated embodiment, the wire pockets 232 are defined by the edge 230. For example, the wire pockets 232 are at an exterior of the substrate 210. In alternative embodiments, the wire pockets 232 may be internal, such as defined by openings passing through the substrate 210, which are remote from the edge 230 located within an interior portion of the substrate 210. Having the wire pockets 232 at the exterior of the substrate 210 allows connection of the printed circuit board assembly 110 to the receptacle connector 104 separate from the wires 40. Having the wire pockets 232 at the interior of the substrate 210 requires passing the wires 40 through the printed circuit board 200 prior to assembly of the printed circuit board assembly 110 to the receptacle connector 104.

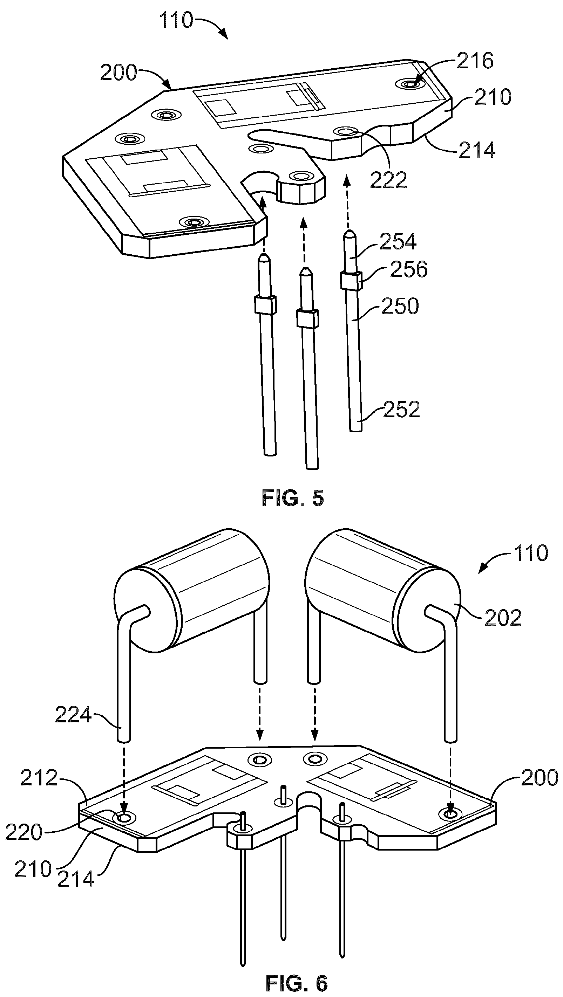

With additional reference to Figure 5, which is an exploded view of a portion of the printed circuit board assembly 110, the printed circuit board assembly 110 includes a plurality of the mating pins 250. The mating pins 250 are configured to be electrically connected to the pin conductors 222 of the printed circuit board 200. In the illustrated embodiment, the printed circuit board assembly 110 includes three of the mating pins 250. Greater or fewer mating pins 250 may be provided in alternative embodiments.

In an exemplary embodiment, each mating pin 250 extends between a mating end 252 and a terminating end 254. The mating end 252 is configured to be mated with the corresponding receptacle contact 122. For example, the mating end 252 is configured to be plugged into the poke in opening 130 in the receptacle housing 120 to mechanically and electrically connect the mating pin 250 to the receptacle contact 122. The terminating end 254 is configured to be terminated to the corresponding circuit 216 of the printed circuit board 200. For example, the terminating end 254 includes a solder tail configured to be soldered to the pin conductor 222. In an exemplary embodiment, the terminating end 254 is configured to be plugged into the plated via of the substrate 210 through the second surface 214. The terminating end 254 is then soldered to the plated via. In other various embodiments, the terminating end 254 may include a compliant pin configured to be press fit into the plated via of the substrate 210. In various embodiments, the mating pin 250 includes tabs 256 extending from sides of the mating pin 250 for mounting to the printed circuit board 200, such as for locating the mating pin 250 at the second surface 214. In an exemplary embodiment, the mating pin 250 is a stamped and formed contact. The mating pin 250 may be square or rectangular. In alternative embodiments, the mating pin 250 may be cylindrical. The mating pin 250 may be chamfered at the mating end 252 and/or the terminating end 254.

With additional reference to Figure 6, which is an exploded view of a portion of the printed circuit board assembly 110, the printed circuit board assembly 110 includes one or more of the electrical components 202. In the illustrated embodiment, the electrical components 202 are surge protection devices. The surge protection devices provide protection for low voltage DC power and signal lines of the electrical connector system 100. However, the electrical components 202 are in no way limited to surge protection devices. Other types of electrical components may be used in alternative embodiments. For example, the electrical components 202 may include one or more power filtering elements, power buffering elements, lightning strike protection elements, power conversion elements, and the like. The electrical components 202 may include one or more signal processing elements, signal monitoring elements, level shifting elements, or other data processing elements. The electrical components 202 may include one or more microprocessors, memory modules, communication modules, and the like. The electrical components 202 include leads 224 configured to be terminated to the component conductors 220. For example, the leads 224 may be soldered tails configured to be soldered to the solder pads and/or plated vias of the printed circuit board 200. The leads 224 may be loaded into the plated vias at the first surface 212 and then soldered to the plated vias. The leads 224 may be trimmed after being soldered to the plated vias. In alternative embodiments, the leads 224 may be surface mounted to solder pads on the first surface 212 of the substrate 210. The printed circuit board assembly 110 may additionally or alternatively include electrical components 202 mounted to the second surface 214. In other embodiments, the leads 224 may form the mating pin 250. For example, rather than having separate mating pins, the leads 224 may pass through the substrate 210 and are configured to be direct plugged into the poke-in openings 130.

In various embodiments, the electrical components 202 may include one or more electrical connectors mounted to the printed circuit board 200. The electrical connectors may include a connector housing holding one or more contacts configured to be terminated to the printed circuit board 200. The electrical connector is configured to be mated with a mating electrical connector or directly to wires, such as power wires or signal wires to connect the wires to the printed circuit board 200.

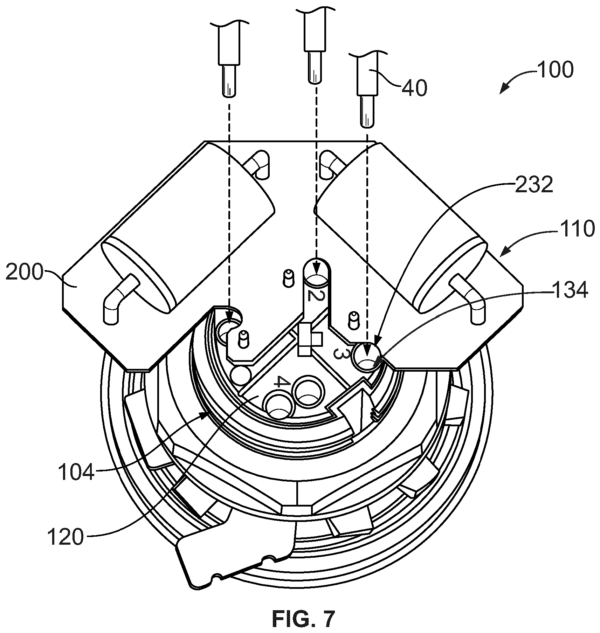

Figure 7 is a perspective view of a portion of the electrical connector system 100 in accordance with an exemplary embodiment showing the printed circuit board assembly 110 coupled to the receptacle connector 104. Figure 7 illustrates one of the wires 40 configured to be terminated to the receptacle connector 104. For example, the wire 40 may be assembled by a poke in connection, wherein the end of the wire 40 is configured to be poked into a wire opening 134 in the receptacle housing 120. In an exemplary embodiment, the wire 40 is configured to pass through the corresponding wire pocket 232 in the printed circuit board 200. In various embodiments, a plurality of the wires 40 are configured to be terminated to the receptacle connector 104. The wires 40 may be power wires and/or signal wires.

In various embodiments, the wire 40 may be terminated to the receptacle connector 104 after the printed circuit board assembly 110 is coupled to the receptacle connector 104. In alternative embodiments, the wire 40 may be terminated to the receptacle connector 104 prior to connecting the printed circuit board assembly 110 to the receptacle connector 104. In some embodiments, the electrical circuit carried by the wires 40 can be electrically connected to the electrical circuits on the printed circuit board assembly 200, via internal elements of the connector system. In other embodiments, the circuits carried by the wires 40 may be independent of the electrical circuits on the printed circuit board assembly 200.

Figure 8 is a sectional view of a portion of the electrical connector system 100 in accordance with an exemplary embodiment. Figure 8 shows the receptacle connector 104 passing through an opening 36 in the fixture housing 34. The printed circuit board assembly 110 is directly mounted to the receptacle connector 104. For example, the printed circuit board assembly 110 is directly connected to the receptacle contacts 122 of the receptacle connector 104, without the need for wires between the receptacle contacts 122 and the printed circuit board 200. For example, the mating pins 250 are directly connected to the receptacle contacts 122 by a poke in connection.

The receptacle contact 122 is received in the corresponding contact channel 124 in the receptacle housing 120. The poke in opening 130 is aligned with the contact channel 124 to allow the mating pin 250 to plug through the poke in opening 130 into the contact channel 124 for direct mating with the receptacle contact 122 by a poke in connection. **In** an exemplary embodiment, the receptacle housing 120 includes a front housing 140 and a rear housing 142. The rear housing 142 separate and discrete from the front housing 140 and coupled thereto. For example, the rear housing 142 is received in a chamber at the rear end of the front housing 140. The front housing 140 includes the contact channels 124. The rear housing 142 includes the poke in openings 130. The rear housing 142 may additionally include the wire openings 134 that receive the wires 40. The wire openings 134 may open to the contact channels 124 to allow termination of the wires 40 to the receptacle contacts 122. For example, the wires 40 may be electrically connected to the receptacle contacts 122 by a poke in connection where the ends of the wires 40 are loaded into a corresponding poke in portion of the receptacle contacts 122 to make a reliable electrical and mechanical connection between the wires 40 and the receptacle contacts 122.

In an exemplary embodiment, each receptacle contact 122 includes a poke in contact 144. The mating end 252 of the mating pin 250 is configured to be mated directly to the poke in contact 144. For example, the mating end 252 is loaded into the poke in contact 144 to create a reliable mechanical and electrical connection between the mating pin 250 and the receptacle contact 122. In an exemplary embodiment, the poke in contact 144 includes a spring beam 146 and a base portion 148. The mating pin 250 is captured between the spring beam 146 and the base portion 148. The spring beam 146 biases the mating pin 250 against the base portion 148 to create a reliable electrical connection between the side of the mating pin 250 and the base portion 148. For example, a large surface area of the mating pin 250 interfaces with the base portion 148 to create a reliable electrical connection therebetween. The spring beam 146 urges the mating pin 250 against the base portion 148. The edge of the spring beam 146 may dig into the side of the mating pin 250 to mechanically hold the mating pin 250 in the receptacle connector 104. The edge of the spring beam 146 may resist pullout of the mating pin 250 from the poke in opening 130. As such, a reliable mechanical and electrical connection is made between the mating pin 250 and the receptacle contact 122. The mating pin 250 creates a direct electrical connection between the receptacle contact 122 and the corresponding circuit 216 on the printed circuit board 200, such as to electrically connect the electrical component 202 with the receptacle contact 122. The poke in connection is quick and reliable. Additionally, all of the mating pins 250 may be simultaneously connected to the receptacle connector 104 by the poke in or and connections. The printed circuit board assembly 110 is mechanically supported by the poke in connections with the receptacle connector 104. For example, the printed circuit board 200 may be freestanding on the mating pins 250, without the need for additional fixturing or support by the fixture housing 34.

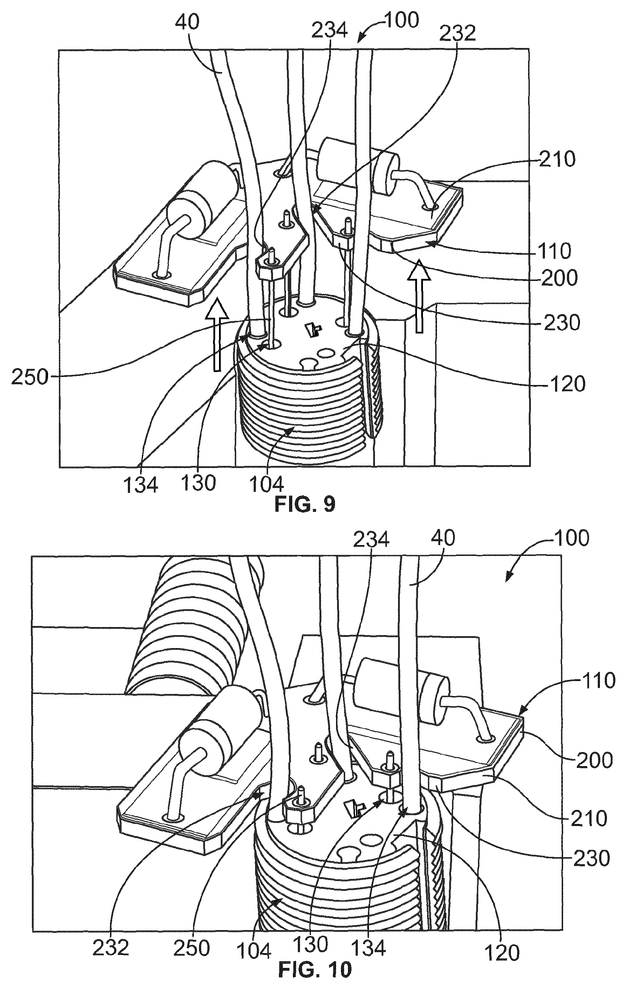

Figure 9 is a perspective view of a portion of the electrical connector system 100 showing the printed circuit board assembly 110 poised for coupling to the receptacle connector 104. Figure 10 is a perspective view of a portion of the electrical connector system 100 showing the printed circuit board assembly 100 coupled to the receptacle connector 104. Figures 9 and 10 show the wires 40 terminated to the receptacle connector 104. The printed circuit board assembly 100 is coupled to the receptacle connector 104 independent of the wires 40. For example, the wires 40 are preassembled to the receptacle connector 104. In various embodiments, the ends of the wires 40 may be poked into the corresponding wire openings 134 in the receptacle housing 120 to electrically connect the wires 40 to the corresponding receptacle contacts 122 (shown in Figure 8).

In an exemplary embodiment, the wires 40 may be used to guide mating of the printed circuit board assembly 100 with the receptacle connector 104. For example, the wires 40 may be received in the wire pockets 232. The wires 40 are used to oriented or position the printed circuit board assembly 100 relative to the wires 40 and the receptacle connector 104. The edges 230 of the substrate 210 engage the wires 40 to align the substrate 210 with the receptacle housing 120. The mating pins 250 are aligned with the poke in openings 130. The printed circuit board assembly 100 may be slid downward along the wires 40 to load the mating pins 250 into the poke in openings 130 to mate the mating pins 250 with the corresponding receptacle contacts 122. As such, the wires 40 are used to guide mating of the mating pins 250 with the receptacle connector 104. The edges 230 forming the wire pockets 232 define guide elements 234 of the printed circuit board 200 used to guide mating of the printed circuit board assembly 100 with the receptacle connector 104. Other types of guide elements may be used in alternative embodiments, such as separate guideposts or guide openings.

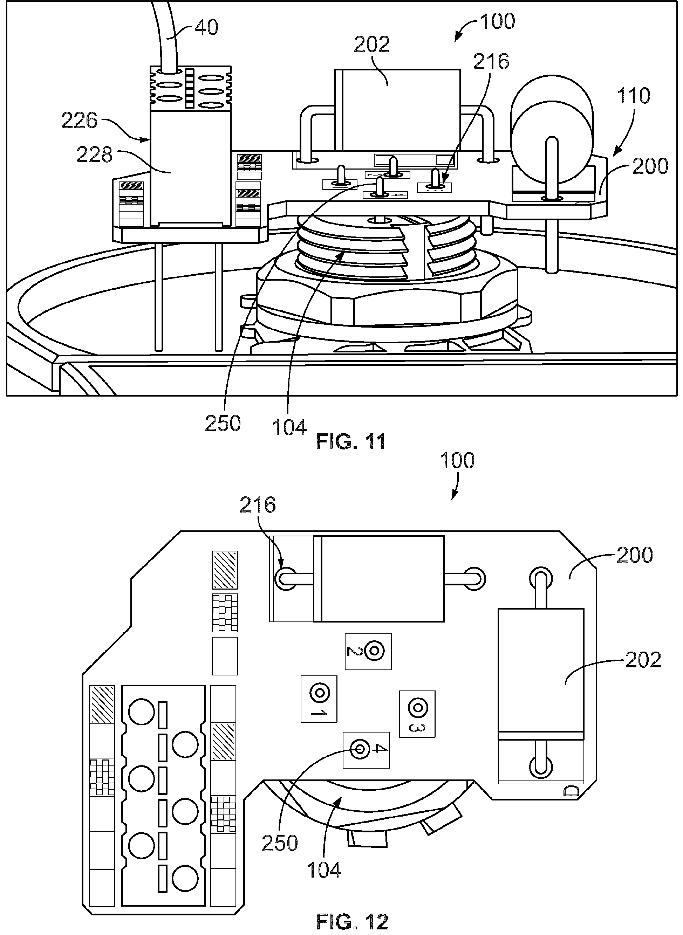

Figure 11 is a side view of a portion of the electrical connector system 100 in accordance with an exemplary embodiment. Figure 12 is a plan view of a portion of the electrical connector system 100 in accordance with an exemplary embodiment. Figures 11 and 12 show the printed circuit board 200 having a different footprint and supporting different electrical components 202. The printed circuit board assembly 110 is shown including a different number of the mating pins 250 in Figures 11 and 12. Additionally, the electrical connector system 100 is shown with the wires 40 electrically connected to the receptacle connector 104 through the printed circuit board assembly 110 rather than directly connecting the wires 40 to the receptacle connector 104.

In an exemplary embodiment, the printed circuit board assembly 100 includes an electrical connector 226 as one of the electrical components 202. The electrical connector 226 is mounted to the printed circuit board 200. The electrical connector 226 includes a connector housing 228 holding contacts (not shown). The contacts are terminated to the printed circuit board 200. The connector housing 228 includes openings that receive the wires 40. The wires 40 are configured to be electrically connected to the receptacle connector 104 through the electrical connector 226, the corresponding circuits 216 of the printed circuit board 200, and the mating pins 250. In various embodiments, the wires 40 may be electrically connected to the electrical connector 226 by poke in connections.

The mating pins 250 of the printed circuit board assembly 110 are made by poke in connections to the receptacle connector 104. All of the mating pins 250 may be simultaneously mated to the receptacle contacts 122 of the receptacle connector 104 by the poke in connections. The mating pins 250 form direct connections between the receptacle contacts 122 and the printed circuit board 200 without the need for wires between the printed circuit board 200 and the receptacle connector 104.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. Dimensions, types of materials, orientations of the various components, and the number and positions of the various components described herein are intended to define parameters of certain embodiments, and are by no means limiting and are merely exemplary embodiments. Many other embodiments and modifications within the scope of the claims will be apparent to those of skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects. Further, the limitations of the following claims are not written in means - plus-function format and are not intended to be interpreted based on 35 U.S.C. § 112, sixth paragraph, unless and until such claim limitations expressly use the phrase "means for" followed by a statement of function void of further structure.

The invention may also reside in any one of the following clauses:
Clause 1 - A printed circuit board assembly comprising:
   a printed circuit board including a substrate having a first surface and a second surface, the printed circuit board including circuits on the substrate;
   an electrical component mounted to the first surface of the substrate and electrically connected to the corresponding circuit or a corresponding said circuit on the substrate; and
   mating pins extending from the second surface of the substrate, each mating pin having a mating end and a terminating end, the terminating end being terminated to the corresponding circuit on the substrate to electrically connect the mating pin to the electrical component;
   wherein the mating ends of the mating pins are configured to be plugged into poke-in openings of a receptacle connector to electrically connect the mating pins to poke-in contacts of the receptacle connector.
Clause 2 - The printed circuit board assembly of clause 1, wherein the printed circuit board is freestanding on the mating pins such that the printed circuit board assembly is mechanically supported by the receptacle connector.
Clause 3 - The printed circuit board assembly of clause 1, wherein the printed circuit board is configured to be directly connected to the receptacle contacts or to receptacle contacts of the receptacle connector by the mating pins.
Clause 4 - The printed circuit board assembly of clause 1, wherein each of the mating pins are simultaneously mated to the poke in contacts of the receptacle contacts or to poke in contacts of receptacle contacts of the receptacle connector.
Clause 5 - The printed circuit board assembly of clause 1, wherein the printed circuit board includes wire pockets therethrough configured to allow wires to pass through the printed circuit board to connect to the receptacle contacts or to receptacle contacts of the receptacle connector.
Clause 6 - The printed circuit board assembly of clause 5, wherein the wire pockets are adjacent the mating pins allowing connection of the wires to the receptacle contacts.

## Claims

1. A printed circuit board assembly (110) comprising:
a printed circuit board (200) including a substrate (210) having a first surface (212) and a second surface (214), the printed circuit board (200) including circuits (216) on the substrate (210);
an electrical component (202) mounted to the first surface (212) of the substrate (210) and electrically connected to the corresponding circuit (216) on the substrate (210); and
mating pins (250) extending from the second surface (214) of the substrate (210), each mating pin (250) having a mating end (252) and a terminating end (254), the terminating end (254) being terminated to the corresponding circuit (216) on the substrate (210) to electrically connect the mating pin (250) to the electrical component (202);
wherein the mating ends (252) of the mating pins (250) are configured to be plugged into poke-in openings (130) of a receptacle connector (104) to electrically connect the mating pins (250) to poke-in contacts (144) of the receptacle connector (104).

2. An electrical connector system (100) comprising:
a receptacle connector (104) including a receptacle housing (120) and receptacle contacts (122) configured to be mated with mating contacts (118) of a mating connector (106), the receptacle housing (120) having contact channels (124) holding the receptacle contacts (122), the receptacle housing (120) having poke-in openings (130) open to the contact channels (124), the receptacle contacts (122) including poke-in contacts (144); and
a printed circuit board assembly (110) of claim 1 coupled to the receptacle connector (104),
wherein the mating ends (252) of the mating pins (250) of the printed circuit board assembly (110) are plugged into poke-in openings (130) of the receptacle connector (104) to electrically connect the mating pins (250) to the poke-in contacts (144) of the receptacle connector (104).

3. The electrical connector system of claim 2, wherein the printed circuit board assembly (110) or printed circuit board (200) is freestanding on the mating pins (250) such that the printed circuit board assembly (110) is mechanically supported by the receptacle connector (104).

4. The electrical connector system of claim 2 or 3, wherein the printed circuit board (200) is directly connected to the receptacle contacts (122) by the mating pins (250).

5. The electrical connector system of claim 2, 3 or 4, wherein the mating pins (250) are mated to the poke in contacts (144) in a mating direction parallel to the pin axes of the mating pins (250).

6. The electrical connector system of any one of claims 2 to 5, wherein the poke in contacts (144) are spring biased against the mating pins (250) to create mechanical and electrical connections to the mating pins (250).

7. The electrical connector system of any one of claims 2 to 6, wherein the mating pins (250) are fixed, rigid conductors between the printed circuit board (200) and the poke in contacts (144) of the receptacle contacts (122).

8. The electrical connector system of any one of claims 2 to 7, wherein each of the mating pins (250) are simultaneously mated to the poke in contacts (144) of the receptacle contacts (122).

9. The electrical connector system of any one of claims 2 to 8, wherein the printed circuit board (200) includes wire pockets (232) therethrough configured to allow wires (40) to pass through the printed circuit board (200) to connect to the receptacle contacts (122).

10. The electrical connector system of claim 9, wherein the wire pockets (232) are adjacent the mating pins (250) allowing connection of the wires (40) to the receptacle contacts (122).

11. The electrical connector system of claim 9 or 10, wherein the receptacle housing (120) includes wire openings (134) adjacent the poke in openings (130) to receive the wires (40) adjacent the mating pins (250) to allow connection of the mating pins (250) and the wires (40) to the receptacle contacts (122).

12. The electrical connector system of any one of claims 2 to 8, wherein the printed circuit board (200) includes guide elements (234) to guide mating of the printed circuit board assembly (110) to the receptacle connector (104).

13. The electrical connector system of claim 12, wherein the guide elements (234) include openings through the printed circuit board (200), the openings form wire pockets (232) configured to receive wires (40) extending from the receptacle connector (104), the printed circuit board (200) configured to be guided by the wires (40) during mating to load the mating ends (252) of the mating pins (250) into the poke in openings (130).

14. The electrical connector system of any one of claims 2 to 8, wherein the printed circuit board assembly (110) includes an electrical connector (226) mounted to the printed circuit board (200), the electrical connector (226) configured to be connected to wires (40), the printed circuit board (200) connecting the wires (40) to the mating pins (250).

15. The electrical connector system of any one of claims 2 to 14, wherein the electrical component (202) includes a surge protection device.
